# EUROPEAN PATENT SPECIFICATION

(11) **EP 2 850 560 B1**
(45) Date of publication and mention of the grant of the patent: **10.10.2018**
(21) Application number: 13729502.8
(22) Date of filing: 21.05.2013
(51) Int. Cl.: G06K 19/04, G06K 19/077

(54) **CHIP CARD DEVICE AND METHOD FOR MANUFACTURE THEREOF**
CHIPKARTENVORRICHTUNG UND VERFAHREN ZUR HERSTELLUNG DAVON
DISPOSITIF À CARTE À PUCE ET SON PROCÉDÉ DE FABRICATION

(30) Priority: 18.05.2012 NL 2008844; 01.06.2012 NL 1039642
(43) Date of publication of application: 25.03.2015
(73) Proprietor: CardPack B.V., 4451 KE Heinkenszand (NL)
(72) Inventor: WILLEMSEN, Louis Rinze Henricus Adrianus, Las Pinas City, Almanza 2 (PH)
(74) Representative: Algemeen Octrooi- en Merkenbureau B.V.
(86) International application number: PCT/NL2013/050370
(87) International publication number: WO 2013/172715

(56) References cited:
- EP-A2- 1 139 281
- CN-U- 201 845 354
- US-A- 5 004 899
- US-A1- 2008 083 831

## Description

The invention relates to a chip card device according to the preamble of claim 1. Such a chip card is generally known as carrier for a SIM card for use in a telephone.

The known chip card comprises a semiconductor substrate in the form of a chip. This chip has a memory, and usually also a microprocessor. On a surface of the card the chip is provided with contact surfaces. The chip of the card can hereby be brought into contact with an external apparatus such that the apparatus can communicate with the data on the card. Cash withdrawals or payments can for instance be made in this way.

Document EP 1 139 281 discloses a data medium card that has a card body and at least one electronic memory component on a manually separable part of the card body. The card body has at least one data field with visually readable data and a cover with several stampings that covers the data and that can be removed irreversibly by scratching or pulling. Similar SIM cards with a breakaway part which carries the confidential puk or pin number are disclosed in documents US 2008083831 and CN 201845354.

Document US 5 004 899 A discloses a semiconductor card which can be folded.

It is a drawback of the known chip card device in general that the chip and the contact surfaces thereof are relatively susceptible to damage. If scratching occurs, this may result in the chip card becoming unusable, this resulting in considerable inconvenience for the user.

According to the prior art the known chip card devices in the form of SIM cards are used for irreversible receiving therein of a SIM (ID-000) or mini-SIM (Mini-UICC). The SIM or mini-SIM is received in a window opening of the card. The user can press the SIM out of the card. The SIM is then placed in a telephone. In order to enable subsequent use of the telephone a code has to be entered (for instance a PIN code or PUK code). This code is printed on a separate code sheet and is supplied together with the SIM card in a combined packaging.

During the production of the SIM card packaging the SIM cards and the associated code sheets have to be transported synchronously. Only in this way is it guaranteed that, during the final packaging of the SIM card with the associated code sheet, the correct code is also packed with the correct SIM card. It is noted here that packaging often takes place at a location other than where the SIM card is produced. This makes production of such a SIM card packaging exceptionally complicated logistically.

It is therefore an object of the present invention to provide a chip card device wherein the logistic challenge associated with the production of the SIM card packagings is reduced. A particular object here is to reduce the risk of damage to the SIM. For this purpose the invention provides a chip card device according to claim 1.

The chip card device according to the invention comprises a card-like carrier having received therein a semiconductor substrate in the form of a chip of a SIM. This chip has at least a memory element and is provided with contact surfaces which are accessible on the surface of the card-like carrier to enable reading of the memory element therewith. The card-like carrier according to the invention comprises a card part with the semiconductor substrate and a further card part adjoining the card part via a fold line such that the further card part is foldable onto the semiconductor substrate of the card part.

Using the chip card device according to the present invention the above described logistical challenge is overcome in that at least one of the sides of the card part and the further card part, which sides are foldable onto each other, is provided with personal user information, such as a code. The code associated with the SIM or mini-SIM can thus be arranged directly onto the chip card device in a simple manner. Because the chip card device is foldable, the personal user information can be immediately screened, so preventing undesired use. No further complicated steps are required in the production process to screen a code provided directly on the card. The chip card device according to the present invention can hereby be produced relatively quickly, easily and inexpensively in secured manner against undesirable use.

Further advantages and embodiments will be discussed below.

Via the fold line the further card part can be folded substantially parallel to the card part with the chip. In the folded state the contact surfaces are directed toward the further card part such that the contact surfaces are protected by the further card part. Scratching of the contact surfaces is therefore prevented during transport of the chip card device in the folded state. This prevents the chip card device becoming unusable.

An additional advantage of the present invention is that the carrier simultaneously serves as packaging. Only one material need hereby be used and further packaging means, such as foils and the like, are no longer necessary. Inexpensive and relatively environmentally-friendly operation is hereby possible. In an embodiment the card part with the chip has a dimension in a direction perpendicularly of the fold line which is substantially equal to the dimension of the further card part in this direction. This means that edges of the card part and of the further card part remote from the fold line lie on each other in the folded state. A compact card device is hereby obtained, at least in the folded state. In an embodiment with a card part and a further card part (and in the absence of further fold lines and card parts) the fold line is situated in the middle between two edges of the chip card device. The fold line is preferably situated in the middle between the longest dimension of the chip card device such that the chip card device is foldable along the long side.

In an embodiment the chip card device has dimensions which correspond to standard dimensions of such chip cards. The chip card generally has dimensions complying with international standards, such as for instance ISO 7810 and ISO 7816/2. A known format is for instance the ID-1 format.

In a particular embodiment however, the chip card device differs from these standard dimensions. In such an embodiment the card part with the chip has a dimension in a direction parallel to the fold line which differs from the dimension of the further card part in this direction. The further card part preferably has the smaller dimension of the two. The dimension of the further card part is preferably such here that in the folded state it amply covers the chip. Varying from the standard ensures that less material can be used. A material saving of about 20% to 40% is possible with the invention. The material saving also provides for lower transport costs.

The standard already referred to above relates to a rectangular card with long sides and short sides. The fold line is preferably formed parallel to the short side. In the present invention the short side can be embodied differently from the standard. The long side does however preferably comply with said standard. A thus modified card is easy to manufacture with existing techniques.

In an embodiment the card is manufactured via a per se known production process, wherein according to the invention a fold line formed by a recess is arranged in the card.

In another embodiment two separate card parts are connected to each other, for instance by means of adhesion, spot welding or other type of connection. Two card parts can be connected to each other in particular by means of a sticker.

In a particular embodiment the card is manufactured by means of an injection moulding process. A fold line is easy to form using such a process. Injection moulding of the card and forming of the fold line can take place in one step, whereby the manufacture by means of injection moulding takes place relatively quickly and inexpensively. Other production methods can however also be envisaged and fall within the intended scope of protection of the invention.

The fold line is formed in simple manner in that it is formed by a recess in the card-like carrier. Such a recess is also referred to as a living hinge and is per se known to the skilled person. The recess is preferably a substantially U- shaped recess in the material. The card is then easily foldable at the position of the thinner cross-section of the card, whereby the two card parts pivot easily along the fold line relative to each other.

The recess is preferably embodied such that pivoting is possible in only one direction. The card is then only foldable in one direction from a flat starting situation to a flat (but thicker) folded situation. The recess is then configured such that in the folded situation the chip is covered by the further card part.

The skilled person, for instance in the field of injection moulding, will be able to develop and apply such a living hinge (with or without unilateral hinge function) to the chip card device according to the present invention. For this purpose the skilled person will for instance modify a die used for a mould.

It is also possible to envisage the chip card device being manufactured in other manner. It is thus conceivable for instance for the chip card device to consist of two separate card parts which are connected to each other in a production process. The two separate card parts can be of the same material, although different materials can also be envisaged. It is possible to make use of two separate card parts, for instance two separate injection-moulded card parts, which makes it relatively simpler to provide the chip card device with a print, since the two separate card parts can easily be printed individually. Following printing the card parts are attached to each other, for instance by means of ultrasonic welding. The personal user information can then be provided on one or more of the card parts. The two card parts can also be connected using a transparent or printed foil. A connection by means of in-mould labelling or in-product labelling, i.e. adding a label with heat and pressure after the card parts have been manufactured, for instance in an injection-moulded product, or other similar techniques can also be envisaged. The foil used can then also serve as outer side of the closed packaging for the purpose of protection against undesired removal of the SIM card chip. The foil can also serve as communication means, or scratch function (lottery and the like) or scent or other marketing and direct mail application.

The card part is preferably situated wholly on one side of the fold line and the further card part is situated wholly on the other side of the fold line. In a folded state the fold line then adjoins an edge of the chip card device. The card is in this way relatively small in the folded state, whereby it can be put away relatively easily.

In a particular embodiment of the chip card device the semiconductor substrate in the form of a chip of a SIM received in the card part is irreversibly releasable from the chip card device. This is possible for instance in that the chip card device is provided with a sub-carrier on which the semiconductor substrate in the form of a chip is provided. The sub-carrier with chip is then for instance a SIM (ID-000), or mini-SIM (Mini-UICC) or another possibly even smaller standard. The card part can comprise for this purpose a window opening in which the semiconductor substrate is received.

A recess-opening is then preferably provided between the semiconductor substrate and the card part for the purpose of irreversible removal of the semiconductor substrate. The recess-opening can be embodied such that it is accessible on a side of the card part and not accessible on the opposite side of the card part. The distance between the edge of the semiconductor substrate and the edge of the window opening can for instance take a narrowing, such as for instance tapering, cross-sectional form such that an opening of for instance 1 mm is available from the removable side of the card part, and that an opening of considerably less than 1 mm, for instance less than 0.25 mm, is available from the non-removable side such that the user can break out the chip from the removable side but not from the non-removable side.

In an embodiment the card part and the further card part are provided with fixing means for holding the chip card device in a folded state. Undesired opening of the chip card device is thus prevented.

In an embodiment in the form of a SIM card it is recommended that the fixing means are breakable only once from a closed situation. Indicator means can be provided here which show that the packaging has already been opened once. A chip card device is in this way obtained which prevents undesired opening. In the unlikely event the chip card device has nevertheless already been opened, the packaging can then be removed from the shop in order to then block the associated mini-SIM.

In a particularly advantageous embodiment the fixing means comprise one or more ultrasonic spot-welds. A semi-permanent connection between the two card parts is in this way possible in a simple manner.

In an embodiment the fixing means comprise a hook element provided close to an outer end of the card-like carrier, and a recess provided close to an outer end of the card-like carrier opposite this outer end. This embodiment can be suitable for a reclosable opening, but also for a packaging for once-only opening. In the latter case it is possible to envisage the hook element breaking off when the chip card device is opened for the first time. The hook element can be provided for this purpose with a weakened zone.

A further repackaging is unnecessary when a recess is provided in the card part and/or the further card part for the purpose of thereby placing the chip card device on a hook profile, such as for instance of a shop rack. Material costs can therefore also be saved here. A through-hole is preferably provided in the chip card device, this through-hole extending through the card part and the further card part.

According to an aspect, the invention provides a method for manufacturing a chip card device according to the invention as defined in claim 14. The method comprises the steps of providing a card part on which the semiconductor substrate in the form of a chip of a SIM is placed, or at least can be placed, and of providing a further card part. It is possible here to envisage the card part, the fold line and the further card part being formed in one integral process, for instance an injection moulding process. It is however also possible to envisage the separate card parts being provided and subsequently connected to each other, for instance by ultrasonic welding or another sealing method.

The card part and/or the further card part are preferably already provided with a print prior to the step of connection. This is possible for instance by first injection moulding the card parts individually and subsequently providing them with a print. Once the print has been provided the card parts are connected to each other as specified above.

According to the invention a print is provided in the form of personal user information, such as a PIN code or PUK code, in particular only after connecting of the card parts.

According to an aspect, the invention provides a method for manufacturing a chip card according to the invention as defined in claim 1. The chip card according to the invention can be manufactured exceptionally quickly and inexpensively by means of an injection moulding process. In the injection moulding process the card-like carrier is produced. The semiconductor substrate can be placed on the card-like carrier during the injection moulding process or later. According to the invention the method comprises the step of providing a linear fold line in the card-like carrier.

In an embodiment the providing of the linear fold line takes place in the injection moulding process. This can take place in simple manner in that the linear fold line is provided in the mould such that the end product has the linear fold line. No additional production processes need therefore be performed, and the card is easy to manufacture.

In an embodiment the providing of the linear fold line takes place by means of a machining technique.

According to the invention personal user information, such as a PIN or PUK code, associated with the chip of the SIM is provided on the card in the form of characters readable by the user. This can take place in simple manner by means of an inmould labelling process. The code can hereby already be preprinted and encapsulated in the carrier during the injection moulding process. This realizes a further saving in material costs but, even more important, the card obtained hereby is a complete end product. The code is already provided on the card, which can be folded double to protect the code and the chip, and the thus obtained folded carrier is in this way packaged and ready for transport. Other than in the prior art, no further production steps need to take place, such as the addition of a sheet with a code and the packaging of the card with the sheet (often at a distance from the initial manufacturing location of the card).

Further advantages and optional further method steps have already been elucidated above with reference to the description of the chip card device itself.

The invention further relates to the use of the chip card device according to the invention.

The invention will be further elucidated hereinbelow on the basis of the description of a preferred embodiment of a chip card device according to the invention, with reference to the following figures, in which:
Figure 1 is a schematic view of a prior art chip card;
Figure 2 is a schematic view of a chip card according to the present invention;
Figure 3 is a view of an embodiment of a chip card according to the present invention;
Figures 4a-b are views of a preferred embodiment of a chip card according to the present invention in respectively a non-folded and a folded state.

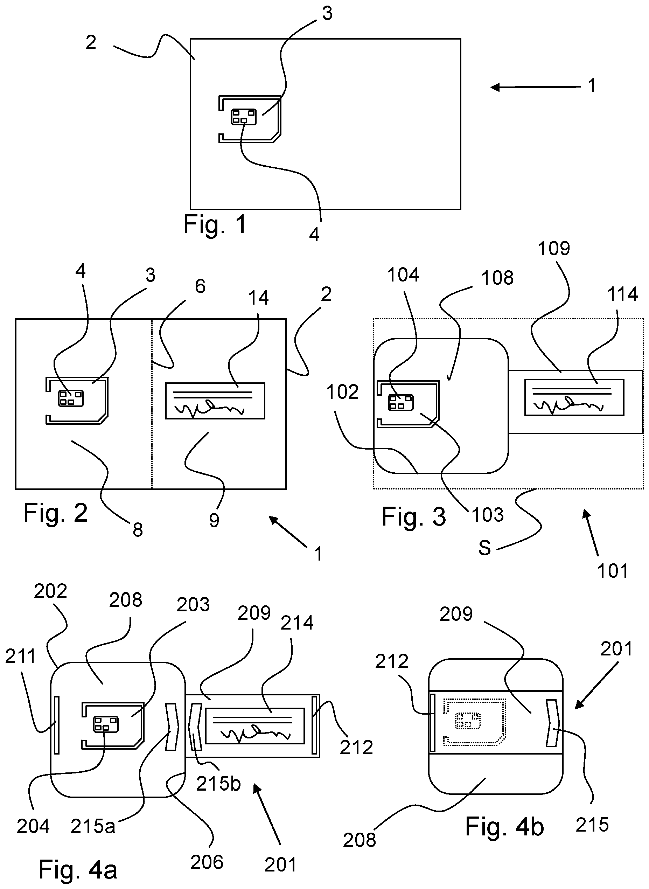

Figure 1 shows a view of a chip card 1 with a SIM according to the prior art as is for instance known as carrier for a removable SIM card for use in a telephone. The known chip card comprises a carrier 2 on which is provided a semiconductor substrate 4 in the form of a chip for a SIM 3. The chip has a memory and a microprocessor (neither shown in further detail). On a surface of the card the chip is provided with contact surfaces. The chip 4 of the card 1 can hereby be placed into contact with an external apparatus such that the apparatus can communicate with the data on the card. Such a chip and its operation are per se known to the skilled person.

Figure 2 shows a view of a chip card 1 according to the present invention. This chip card once again comprises a carrier 8,9 on which is provided a semiconductor substrate in the form of a chip 4 for a SIM 3. The chip card 1 is however divided here by means of a fold line 6 into two card parts 8,9 which can rotate relative to each other along the fold line 6. The first card part 8 comprises the chip. In this embodiment the second card part 9 is free of the chip 4 but is provided with user information 14 associated with the SIM 3. The fold line 6 divides the chip card 1 in this case into two equal halves 8,9 which are foldable and placeable onto each other by means of pivoting one of the parts along the fold line 6. Following folding, the chip is as it were situated between the two card parts 8,9 such that the contact surfaces directed toward the further card part 9 are protected from scratching. The lifespan of the card is thus increased in that the chance of scratches on the contact surface, and thereby of the card becoming unusable, is reduced. The user information 14 is concealed from the view of the user.

Figure 3 shows an alternative embodiment of a chip card 101 according to the present invention, wherein a considerable saving in material is possible. It is here also the case that the chip card 101 comprises a carrier 108, 109 on which a chip 104 is provided. The carrier is provided with a fold line 106 with which the card is divided into two parts. A card part 108 is provided with the SIM 103, while the further card part 109 is provided with user information 1 14 associated with the SIM 103. The two card parts 108, 109 are foldable toward each other via the fold line 106. It can be seen that the first card part 108 comprises the chip 104. In order to enable reading of the chip, and still save material, the width (vertical direction in Figure 3) of the card is slightly smaller than the standard size (indicated with broken line S), this standard size being shown for instance in Figure 2. The length (horizontal direction in Figure 3) is the same as the standard size in order to keep production simple. The further card part 109 has the sole function of protecting the chip 104 on the card 101, whereby it has a height which is just slightly greater than the height of the chip 104. The further card part can hereby have a width (vertical direction in Figure 3) which is many times smaller than the standard size. It can be seen that a very large amount of material can hereby be saved. In the present case the saving may amount to about 20%, or 30% or even 40%. Owing to the double folding the personal user information 114 associated with the SIM is also protected against unauthorized use, since this information 114 lies against the card part 104 in the folded state.

Figure 4a shows a further embodiment of the present invention. In this case the chip card 201 is a card with a once-only releasable sub-chip card 203 on which the semiconductor substrate 204 in the form of a chip 204 is provided. In the shown embodiment the chip is a mini-chip 204, which is widely applied on SIM cards (ID-000 or Mini-UICC) for use in a mobile phone. The chip can of course also be a different chip, or any other releasable chip. The sub-card 203 with chip 204 is received in a window of the carrier 208, 209. The sub-card 203 can be released via breaking means.

Similarly to the situation described in Figure 3, the carrier 208, 209 is divided into two parts. The two card parts 208, 209 are connected to each other for this purpose via a fold line 206. The fold lines can be embodied in a manner per se known to the skilled person. In an embodiment which is easy to produce the fold line is formed by means of a U-shaped recess in the carrier 208, 209. Other cross- sections can of course also be envisaged. The carrier 208, 209 and the fold line are preferably manufactured from one integral component which can preferably be manufactured in simple manner by means of injection moulding.

In another embodiment the carrier 208, 209 is manufactured from two separate card parts which are later connected to each other. The two separate card parts can be of the same material, although it is possible to envisage different materials being applied. The connection can for instance be effected by means of ultrasonic welding.

The width of the card part 208 is slightly smaller here than the width of the standard ID-1 size, but is just large enough that the user has some grip when pressing out the sub-card 203 with the mini-chip 204. On either side of the sub-card 203 (top and bottom in Figure 4a) the card part 208 has portions having the same width as the sub-card 203.

The card part 209 is provided with a label carrying confidential user information, such as for instance a PIN code for activating the mini-chip, a PUK code, a telephone number or other information. The first card part 208 is further provided with a first fixing member 211, while the second card part 209 is provided with a second fixing member 212 co-acting with the first fixing member 211. The first and second fixing members 211, 212 can for instance comprise a slot and a protruding edge. After the card 201 has been folded along the fold line, the fixing members can engage mutually in order to thus close the card firmly. The confidential user information is in this way protected and no longer visible to third parties. It is possible to envisage such fixing members 211, 212 also being applied in other embodiments of the invention described here. It is further possible to envisage the fixing members 211, 212 being connectable to each other in reversibly releasable manner. In the situation shown in Figure 4a it is however recommended that the fixing in the folded state is only breakable once. The user can thus see that the confidential information 214 has already been viewed.

The fixing members 211, 212 can be configured here such that, when they are released, one fixing member or both fixing members break(s). It is optionally also possible to envisage one or a number of spot welds being applied so as to seal the card in the folded state. Other embodiments can however also be envisaged.

In an embodiment (not shown) the fixing members comprise a fixing member in the form of a U-shaped element such as a gutter extending over the length (horizontal direction in Figure 4a) of the further card part 209 and an associated fixing member in the form of an L-shaped element, for instance a raised gutter, extending over the length of the card part. The U-shaped gutter is preferably provided on or at the edge of the further card part. The L-shaped element then extends on a side of the chip. The U-shaped element can then hook with a leg of the U behind the foot of the L-shaped element so that a permanent or preferably releasable attachment is possible. An L-shaped element is preferably provided on either side of the chip and a U-shaped element on both edges of the further card part so that a proper closure and protection of the chip are obtained.

As shown in Figure 4a, recesses 215a, 215b are provided in the card part 208 and the further card part 209. These are placed such that, when the card is folded double, one through-opening 215 (see Figure 4b) is formed. Using this opening the card can be placed in the closed situation on a hook profile, such as for instance of a shop rack. The opening can have various shapes and dimensions. It is for instance possible to apply a round hole, or any other suitable alternative. In an embodiment (not shown) only the large card part 208 is provided with an opening with which the card can be placed on a shop rack. This opening is then provided on a side of the card that is opposite the chip.

The card can be manufactured in simple manner by means of existing production techniques. In an embodiment the card is manufactured in an injection moulding process. The length of the card has dimensions here which correspond to the standard size of such a chip card (credit card format), and the width can be slightly smaller. With a small modification of the existing machines it therefore becomes possible to manufacture the cards, which use considerably less material (as shown in Figure 3 and Figure 4).

It is further possible to envisage the card having a relatively irregular form, for instance in the form of a logo, image contour or other shape.

It will be apparent to the skilled person that the invention has been described above on the basis of several possible preferred embodiments. The invention is however not limited to these embodiments. Within the context of the invention many possible equivalent modifications can be envisaged which possibly fall within the scope of protection sought with the appended claims.

## Claims

1. A chip card device (1), comprising a card-like carrier (2) having received therein a semiconductor substrate (4) in the form of a chip of a SIM (203), wherein the chip (4) comprises at least a memory element and is provided with contact surfaces which are accessible on the surface of the card-like carrier to enable reading of the memory element therewith, wherein the chip of the SIM (203) is further releasable from the card-like carrier for use of the chip of the SIM (203) in for instance a mobile phone, **characterized in that** the card-like carrier comprises a card part (8) with the chip (4) of the SIM (203) and a further card part (9) adjoining the card part (8) via a fold line (6) which is formed by a recess in the card-like carrier (2) such that the further card part (9) is foldable onto the semiconductor substrate (4) of the card part (8), wherein at least one of the sides of the card part and the further card part, which sides are foldable onto each other, is provided with personal user information (214) associated with the SIM, such as a PIN code or PUK code, such that the other of the card part and the further card part covers this personal user information (214) when they are folded onto each other.

2. A chip card device according to claim 1, wherein the card part and the further card part are provided with fixing means (211, 212) for holding the chip card device in a folded state.

3. A chip card device according to claim 2, wherein the fixing means (211, 212) are breakable only once from a closed situation.

4. A chip card device according to claim 3, wherein indicator means are provided which are configured to show when the card-like carrier (2) has already been opened once.

5. A chip card device according to claim 2, 3 or 4, wherein the fixing means comprise one or more ultrasonic spot-welds.

6. A chip card device according to claim 2, 3, 4, or 5, wherein the fixing means comprise a hook element (212) provided close to an outer end of the card-like carrier, and a slot (211) provided close to an outer end of the card-like carrier opposite this outer end.

7. A chip card device according to any of the foregoing claims, wherein the card part (8) has a dimension in a direction perpendicularly of the fold line which is substantially equal to the dimension of the further card part (9) in this direction.

8. A chip card device according to any of the foregoing claims, wherein the card part (108) has a dimension in a direction parallel to the fold line (106) which differs from the dimension of the further card part (109) in this direction.

9. A chip card device according to any of the foregoing claims, wherein the recess is a substantially U-shaped recess.

10. A chip card device according to one or more of the foregoing claims, wherein the fold line (6) defines a whole side of the card part or the further card part.

11. A chip card device according to one or more of the foregoing claims, wherein the chip of the SIM (203) received in the card part is irreversibly releasable from the carrier (202).

12. A chip card device according to claim 11, wherein the card part comprises a window opening in which the chip of the SIM (203) is received.

13. A chip card device according to one or more of the foregoing claims, wherein a further recess is provided in the card part and/or the further card part for the purpose of thereby placing the chip card device on a hook profile, such as for instance of a shop rack.

14. A method for manufacturing a chip card device (1) according to one or more of the foregoing claims, comprising the steps of providing a card part (8) on which the semiconductor substrate (4) in the form of a chip of a SIM is placed, and of providing a further card part (9) adjoining the card part (8) via a fold line (6) which is formed by a recess such that the further card part (9) is foldable onto the semiconductor substrate (4) of the card part (8), and wherein the card part and/or the further card part are provided with personal user information associated with the SIM, such as a PIN code or PUK code.

15. The use of a chip card device (1) according to one or more of the foregoing claims 1 to 13.

## Patentansprüche

1. Chipkartenvorrichtung (1), umfassend einen kartenartigen Träger (2), in dem ein Halbleitersubstrat (4) in Form eines Chips eines SIM (203) aufgenommen ist, wobei der Chip (4) wenigstens ein Speicherelement umfasst und mit Kontaktflächen versehen ist, die auf der Oberfläche des kartenartigen Trägers zugänglich sind, um das Lesen des Speicherelements damit zu ermöglichen, wobei der Chip des SIM (203) ferner von dem kartenartigen Träger für die Verwendung des Chips des SIM (203) in beispielsweise einem Mobiltelefon lösbar ist,
**dadurch gekennzeichnet, dass**
der kartenartige Träger einen Kartenteil (8) mit dem Chip (4) des SIM (203) und einen weiteren Kartenteil (9) umfasst, der an den Kartenteil (8) über eine Faltlinie (6) angrenzt, die durch eine Vertiefung in dem kartenartigen Träger (2) gebildet ist, sodass der weitere Kartenteil (9) auf das Halbleitersubstrat (4) des Kartenteils (8) faltbar ist, wobei wenigstens eine der Seiten von dem Kartenteil und dem weiteren Kartenteil, die aufeinander faltbar sind, mit einer dem SIM zugeordneten persönlichen Benutzerinformation (214) versehen ist, wie zum Beispiel einem PIN-Code oder PUK-Code, so dass der andere von dem Kartenteil und dem weiteren Kartenteil diese persönliche Benutzerinformation (214) bedeckt, wenn sie aufeinander gefaltet sind.

2. Chipkartenvorrichtung nach Anspruch 1, wobei der Kartenteil und der weitere Kartenteil mit Befestigungsmitteln (211, 212) zum Halten der Chipkartenvorrichtung in einem gefalteten Zustand versehen sind.

3. Chipkartenvorrichtung nach Anspruch 2, wobei die Befestigungsmittel (211, 212) nur einmal aus einer geschlossenen Situation zerbrechbar sind.

4. Chipkartenvorrichtung nach Anspruch 3, wobei Anzeigemittel vorgesehen sind, die konfiguriert sind, um zu zeigen, wenn der kartenartige Träger (2) bereits einmal geöffnet worden ist.

5. Chipkartenvorrichtung nach Anspruch 2, 3 oder 4, wobei die Befestigungsmittel einen oder mehrere Ultraschall-Schweißpunkte umfassen.

6. Chipkartenvorrichtung nach Anspruch 2, 3, 4 oder 5, wobei die Befestigungsmittel ein Hakenelement (212), das nahe eines äußeren Endes des kartenartigen Trägers vorgesehen ist, und einen Spalt (211) umfassen, der nahe eines äußeren Endes des kartenartigen Trägers gegenüber diesem äußeren Ende vorgesehen ist.

7. Chipkartenvorrichtung nach einem der vorhergehenden Ansprüche, wobei der Kartenteil (8) in einer Richtung senkrecht zu der Faltlinie eine Abmessung aufweist, die im Wesentlichen gleich der Abmessung des weiteren Kartenteils (9) in dieser Richtung ist.

8. Chipkartenvorrichtung nach einem der vorhergehenden Ansprüche, wobei der Kartenteil (108) in einer Richtung parallel zu der Faltlinie (106) eine Abmessung aufweist, die sich von der Abmessung des weiteren Kartenteils (109) in dieser Richtung unterscheidet.

9. Chipkartenvorrichtung nach einem der vorhergehenden Ansprüche, wobei die Vertiefung eine im Wesentlichen U-förmige Vertiefung ist.

10. Chipkartenvorrichtung nach einem oder mehreren der vorhergehenden Ansprüche, wobei die Faltlinie (6) eine ganze Seite des Kartenteils oder des weiteren Kartenteils definiert.

11. Chipkartenvorrichtung nach einem oder mehreren der vorhergehenden Ansprüche, wobei der Chip des SIM (203), der in dem Kartenteil aufgenommen ist, irreversibel von dem Träger (202) lösbar ist.

12. Chipkartenvorrichtung nach Anspruch 11, wobei der Kartenteil eine Fensteröffnung umfasst, in der der Chip des SIM (203) aufgenommen ist.

13. Chipkartenvorrichtung nach einem oder mehreren der vorhergehenden Ansprüche, wobei in dem Kartenteil und/oder dem weiteren Kartenteil eine weitere Vertiefung zwecks des Anordnens der Chipkartenvorrichtung damit auf einem Hakenprofil, wie zum Beispiel eines Ladenregals, vorgesehen ist.

14. Verfahren zum Herstellen einer Chipkartenvorrichtung (1) nach einem oder mehreren der vorhergehenden Ansprüche, umfassend die Schritte des Bereitstellens eines Kartenteils (8), auf dem das Halbleitersubstrat (4) in Form eines Chips eines SIM angeordnet ist, und des Bereitstellens eines weiteren Kartenteils (9), der an den Kartenteil (8) über eine Faltlinie (6) angrenzt, die durch eine Vertiefung gebildet ist, sodass der weitere Kartenteil (9) auf das Halbleitersubstrat (4) des Kartenteils (8) faltbar ist, und wobei der Kartenteil und/oder der weitere Kartenteil mit einer dem SIM zugeordneten persönlichen Benutzerinformation versehen sind, wie zum Beispiel einem PIN-Code oder PUK-Code.

15. Verwendung einer Chipkartenvorrichtung (1) nach einem oder mehreren der vorhergehenden Ansprüche 1 bis 13.

## Revendications

1. Dispositif à carte à puce (1), comprenant un support de type carte (2) dans lequel est reçu un substrat semi-conducteur (4) sous la forme d'une puce de carte SIM (203), où la puce (4) comprend au moins un élément de mémoire et est munie de surfaces de contact qui sont accessibles sur la surface du support de type carte pour permettre la lecture de l'élément de mémoire avec celles-ci, où la puce de la carte SIM (203) est en outre détachable du support de type carte pour une utilisation de la puce de la carte SIM (203) par exemple dans un téléphone mobile, **caractérisé en ce que** le support de type carte comprend une partie de carte (8) ayant la puce (4) de la carte SIM (203) et une partie de carte supplémentaire (9) adjacente à la partie de carte (8) par l'intermédiaire d'une ligne de pliage (6) qui est formée par un évidement dans le support de type carte (2) de sorte que la partie de carte supplémentaire (9) puisse être pliée sur le substrat semi-conducteur (4) de la partie de carte (8), où au moins l'un des côtés de la partie de carte et de la partie de carte supplémentaire, lesquels côtés sont pliables l'un sur l'autre, est muni d'informations personnelles d'utilisateur (214) associées à la carte SIM, telles qu'un code PIN ou un code PUK, de sorte que l'autre côté de la partie de carte et de la partie de carte supplémentaire couvre ces informations personnelles d'utilisateur (214) lorsqu'ils sont pliés l'un sur l'autre.

2. Dispositif à carte à puce selon la revendication 1, dans lequel la partie de carte et la partie de carte supplémentaire sont munies de moyens de fixation (211, 212) pour maintenir le dispositif à carte à puce dans un état plié.

3. Dispositif à carte à puce selon la revendication 2, dans lequel les moyens de fixation (211, 212) ne peuvent être rompus qu'une seule fois à partir d'une situation fermée.

4. Dispositif à carte à puce selon la revendication 3, dans lequel des moyens indicateurs qui sont configurés pour montrer quand le support de type carte (2) a déjà été ouvert une fois sont prévus.

5. Dispositif à carte à puce selon la revendication 2, 3 ou 4, dans lequel les moyens de fixation comprennent un ou plusieurs point(s) de soudure par ultrasons.

6. Dispositif à carte à puce selon la revendication 2, 3, 4, ou 5, dans lequel les moyens de fixation comprennent un élément de crochet (212) prévu près d'une extrémité extérieure du support de type carte, et une fente (211) prévue près d'une extrémité extérieure du support de type carte opposée à cette extrémité extérieure.

7. Dispositif à carte à puce selon l'une des revendications précédentes, dans lequel la partie de carte (8) a une dimension dans une direction perpendiculaire à la ligne de pliage qui est sensiblement égale à la dimension de la partie de carte supplémentaire (9) dans cette direction.

8. Dispositif à carte à puce selon l'une des revendications précédentes, dans lequel la partie de carte (108) a une dimension dans une direction parallèle à la ligne de pliage (106) qui diffère de la dimension de la partie de carte supplémentaire (109) dans cette direction.

9. Dispositif à carte à puce selon l'une des revendications précédentes, dans lequel l'évidement est un évidement sensiblement en forme de U.

10. Dispositif à carte à puce selon une ou plusieurs des revendications précédentes, dans lequel la ligne de pliage (6) définit un côté entier de la partie de carte or de la partie de carte supplémentaire.

11. Dispositif à carte à puce selon une ou plusieurs des revendications précédentes, dans lequel la puce de la carte SIM (203) reçue dans la partie de carte est détachable de manière irréversible du support (202).

12. Dispositif à carte à puce selon la revendication 11, dans lequel la partie de carte comprend une ouverture de fenêtre où la puce de la carte SIM (203) est reçue.

13. Dispositif à carte à puce selon une ou plusieurs des revendications précédentes, dans lequel un évidement supplémentaire est prévu dans la partie de carte et/ou la partie de carte supplémentaire dans le but de placer ainsi le dispositif à carte à puce sur un profil en forme de crochet, tel que par exemple un rayon de magasin.

14. Procédé de fabrication d'un dispositif à carte à puce (1) selon une ou plusieurs des revendications précédentes, comprenant les étapes consistant à fournir une partie de carte (8) sur laquelle est placé le substrat semi-conducteur (4) sous la forme d'une puce de carte SIM, et à fournir une partie de carte supplémentaire (9) adjacente à la partie de carte (8) par l'intermédiaire d'une ligne de pliage (6) qui est formée par un évidement de sorte que la partie de carte supplémentaire (9) puisse être pliée sur le substrat semi-conducteur (4) de la partie de carte (8), et où la partie de carte et/ou la partie de carte supplémentaire est/sont munie(s) d'informations personnelles d'utilisateur associées à la carte SIM, telles qu'un code PIN ou un code PUK.

15. Utilisation d'un dispositif à carte à puce (1) selon une ou plusieurs des revendications précédentes 1 à 13.
